# DEMANDE DE BREVET EUROPEEN

(11) **EP 4 671 775 A1**
(43) Date de publication de la demande: **31.12.2025**
(21) Numéro de dépôt: 25184733.1
(22) Date de dépôt: 24.06.2025
(51) Int. Cl.: G01R 31/00, G01R 31/327

(54) **PROCEDE ET SYSTEME DE SURVEILLANCE DE LA PERFORMANCE D'UN INTERRUPTEUR ELECTROMECANIQUE COMPRIS DANS UN SYSTEME DE DISTRIBUTION D ENERGIE AU SEIN D'UN AERONEF**

(30) Priorité: 25.06.2024 FR 2406838
(71) Demandeur: Airbus Operations (S.A.S.), 31060 Toulouse Cedex 9 (FR)
(72) Inventeur: BROUQUI, Manon, 31060 Toulouse (FR)
(74) Mandataire: Cabinet Le Guen Maillet

(57) **Abrégé**

Il est proposé un procédé de surveillance de la performance d'un interrupteur électromécanique donné parmi une pluralité d'interrupteurs électromécaniques, de type contacteur ou relais, compris dans un système de distribution d'énergie électrique au sein d'un aéronef. Le procédé comporte : détecter un changement d'état de l'interrupteur électromécanique donné ; vérifier, pour chaque interrupteur électromécanique lié d'un groupement prédéterminé, si celui-ci a également subi un changement d'état ; considérer que le changement d'état de l'interrupteur électromécanique donné est normal, si au moins un interrupteur électromécanique lié du groupement a également subi un changement d'état, ou anormal, sinon ; et en cas de changement d'état anormal, déclencher une alerte. Ainsi, il est possible d'effectuer une surveillance de la performance de l'interrupteur électromécanique donné, de manière simple, fiable et permettant d'anticiper d'éventuelles interruptions de fonctionnement en levant des alertes de maintenance suffisamment à l'avance.

## Description

### DOMAINE TECHNIQUE

Le domaine de l'invention est celui de la surveillance de l'état de santé (« Health Monitoring » en anglais) et de la maintenance des aéronefs.

Plus précisément, la présente invention concerne un procédé de surveillance de la performance d'un interrupteur électromécanique, de type contacteur ou relais, compris dans un système de distribution d'énergie électrique au sein d'un aéronef.

La présente invention concerne également : un système de surveillance adapté à la mise en œuvre d'un tel procédé de surveillance ; un produit programme d'ordinateur et un support de stockage permettant la mise en œuvre d'un tel procédé de surveillance ; et un procédé de maintenance s'appuyant sur un tel procédé de surveillance.

### ETAT DE LA TECHNIQUE ANTERIEURE

Les aéronefs sont soumis à des conditions extrêmes lorsqu'ils naviguent dans les airs, notamment en termes de variations de température, de pression et de vitesse. Les performances de leurs composants doivent être régulièrement vérifiées afin d'assurer leur bon fonctionnement.

La maintenance préventive ou prédictive consiste à effectuer des contrôles et des réparations avant qu'une panne ne se manifeste.

Dans le domaine de l'aéronautique, la maintenance permet notamment d'améliorer la disponibilité et la performance d'un aéronef en évitant son immobilisation au sol (AOG, pour « Aircraft On Ground » en anglais), et de réduire les coûts de maintenance en permettant d'identifier à l'avance des opérations de maintenance en fonction des performances réelles de l'aéronef.

La surveillance de l'état de santé de l'aéronef à des fins de maintenance comprend une collecte des données techniques dès la mise sous tension de l'aéronef, puis pendant le vol et jusqu'à son arrêt. Les données ainsi collectées sont notamment utilisées pour calculer les différents indicateurs sur lesquels s'appuie la maintenance, et donc la programmation d'opérations de maintenance.

L'utilisation des données peut avoir lieu pendant le vol (on parle alors de surveillance de la santé au cours du vol, ou « In-flight health monitoring » en anglais) et/ou après le vol (par exemple si le volume de données à traiter nécessite des ressources de calcul plus élevées). Les calculs utilisant les données collectées peuvent donc être effectués dans l'aéronef et/ou dans un ou plusieurs équipements au sol. Dans le second cas, les équipements (calculateurs) au sol reçoivent, en temps réel ou en différé, les données collectées dans l'aéronef.

L'observation de l'état de santé d'un aéronef sur plusieurs vols permet au personnel au sol de prendre des décisions et de planifier les opérations de maintenance à l'avance, ce qui permet de gagner de précieux temps d'exécution. Le personnel au sol peut ainsi prendre des décisions appropriées en fonction de la criticité, de la logistique et des contrôles de maintenance à venir, et préparer à l'avance les réparations et les remplacements.

Dans le cadre de cette maintenance, il existe en particulier un besoin d'effectuer une surveillance de la performance d'interrupteurs électromécaniques, de type contacteur ou relais, compris dans un système de distribution d'énergie électrique au sein d'un aéronef. Pour cela, il convient de disposer d'une solution qui soit fiable et simple à mettre en œuvre, et qui permette d'anticiper d'éventuelles interruptions de fonctionnement (« Operational Interrupts ») en levant des alertes de maintenance suffisamment à l'avance.

### EXPOSE DE L'INVENTION

Il est proposé ici un procédé de surveillance d'une performance d'un interrupteur électromécanique donné parmi une pluralité d'interrupteurs électromécaniques, de type contacteur ou relais, compris dans un système de distribution d'énergie électrique au sein d'un aéronef, le procédé étant implémenté par un système de surveillance sous forme de circuiterie électronique, le procédé comportant :
a) détecter un changement d'état de l'interrupteur électromécanique donné, depuis un état « ouvert » vers un état « fermé » ou inversement, en fonction de données collectées informant sur l'état de l'interrupteur électromécanique donné ;
b) vérifier, pour chaque interrupteur électromécanique lié appartenant à un groupement prédéterminé comprenant un ou plusieurs interrupteurs électromécaniques qui sont liés à l'interrupteur électromécanique donné et font partie de la pluralité d'interrupteurs électromécaniques, si ledit interrupteur électromécanique lié a également subi un changement d'état, depuis un état « ouvert » vers un état « fermé » ou inversement, en fonction de données collectées informant sur l'état de l'interrupteur électromécanique lié, chaque interrupteur électromécanique lié du groupement étant configuré, par une logique de contrôle et de reconfiguration, pour changer d'état si l'interrupteur électromécanique donné change d'état dans le cadre d'une reconfiguration particulière du système de distribution d'énergie électrique qui est fonction d'une disponibilité de sources électriques du système de distribution d'énergie électrique ;
c) considérer que le changement d'état de l'interrupteur électromécanique donné est normal, si au moins un interrupteur électromécanique lié du groupement a également subi un changement d'état, ou anormal, si aucun interrupteur électromécanique lié du groupement n'a subi un changement d'état ; et
d) en cas de changement d'état anormal de l'interrupteur électromécanique donné, déclencher une alerte relative à la performance de l'interrupteur électromécanique donné.

Ainsi, il est possible d'effectuer une surveillance de la performance d'un interrupteur électromécanique donné, de type contacteur ou relais, parmi une pluralité d'interrupteurs électromécaniques compris dans un système de distribution d'énergie électrique au sein d'un aéronef, grâce à une solution qui est fiable et simple à mettre en œuvre, et qui permet d'anticiper d'éventuelles interruptions de fonctionnement en levant des alertes de maintenance suffisamment à l'avance.

Selon un mode de réalisation particulier, le groupement comprend :
- au moins un premier interrupteur électromécanique lié qui est configuré, par la logique de contrôle et de reconfiguration, pour changer d'état si l'interrupteur électromécanique donné change d'état dans le cadre d'une première reconfiguration particulière du système de distribution d'énergie électrique qui est fonction d'un premier contexte de disponibilité des sources électriques du système de distribution d'énergie électrique ; et
- au moins un deuxième interrupteur électromécanique lié qui est configuré, par la logique de contrôle et de reconfiguration, pour changer d'état si l'interrupteur électromécanique donné change d'état dans le cadre d'une deuxième reconfiguration particulière du système de distribution d'énergie électrique qui est fonction d'un deuxième contexte de disponibilité des sources électriques du système de distribution d'énergie électrique.

Selon un mode de réalisation particulier, les opérations a), b) et c) sont exécutées N fois en parallèle, N>1, avec à chaque fois des données collectées par un enregistreur distinct. En outre, l'alerte relative à la performance de l'interrupteur électromécanique donné est déclenchée si, à l'issue d'au moins une des N exécutions des étapes a), b) et c), le changement d'état de l'interrupteur électromécanique donné est considéré anormal.

Ainsi, il est possible de tenir compte d'un changement d'état anormal de l'interrupteur électromécanique donné, même s'il est détecté à partir des données collectées par un seul des N enregistreurs.

Selon un mode de réalisation particulier, pour au moins une période temporelle prédéterminée de collecte des données informant sur l'état de l'interrupteur électromécanique donné, les opérations b) et c) sont exécutées après chaque détection d'un changement d'état de l'interrupteur électromécanique donné. En outre, l'alerte relative à la performance de l'interrupteur électromécanique donné est déclenchée si le nombre de changement d'état anormal due l'interrupteur électromécanique donné, sur la au moins une période temporelle prédéterminée de collecte, est supérieur ou égal à un seuil prédéterminé.

Ainsi, il est possible de travailler sur des données collectées pendant une ou plusieurs périodes temporelles de collecte, et le choix du seuil permet d'adapter la réactivité du déclenchement d'une alerte.

Selon un mode de réalisation particulier, chaque période temporelle prédéterminée de collecte est une partie d'une plage temporelle d'un vol de l'aéronef définie en fonction d'un paramètre de phase de vol de l'aéronef.

Ainsi, il est possible de retenir les données collectées, au cours d'un ou plusieurs vols de l'aéronef, qui présentent le plus d'intérêt pour décider si une alerte relative à la performance de l'interrupteur électromécanique donné doit être déclenchée.

Selon un mode de réalisation particulier, la vérification d'un changement d'état, pour chaque interrupteur électromécanique lié appartenant au groupement, est limitée à une fenêtre temporelle de vérification, possédant une durée prédéterminée et entourant un instant de détection d'un changement d'état de l'interrupteur électromécanique donné.

Ainsi, on améliore la décision prise quant à un éventuel changement d'état anormal de l'interrupteur électromécanique donné.

Il est aussi proposé un produit programme d'ordinateur, comportant des instructions entraînant l'exécution, par un processeur, du procédé de surveillance évoqué ci-dessus selon l'un quelconque de ses modes de réalisation, lorsque lesdites instructions sont exécutées par le processeur.

Il est aussi proposé un support de stockage, stockant de telles instructions.

Il est aussi proposé un système de surveillance d'une performance d'un interrupteur électromécanique donné parmi une pluralité d'interrupteurs électromécaniques, de type contacteur ou relais, compris dans un système de distribution d'énergie électrique au sein d'un aéronef, le système de surveillance comprenant une circuiterie électronique configurée pour implémenter procédé évoqué ci-dessus selon l'un quelconque de ses modes de réalisation.

Il est aussi proposé un procédé de maintenance d'un interrupteur électromécanique donné parmi une pluralité d'interrupteurs électromécaniques, de type contacteur ou relais, compris dans un système de distribution d'énergie électrique au sein d'un aéronef, le procédé comportant :
- exécuter le procédé évoqué ci-dessus selon l'un quelconque de ses modes de réalisation, pour surveiller la performance de l'interrupteur électromécanique donné ; et
- en cas de déclenchement d'une alerte relative à la performance de l'interrupteur électromécanique donné, réaliser au moins une opération de maintenance sur l'interrupteur électromécanique donné.

### BREVE DESCRIPTION DES DESSINS

Les caractéristiques de l'invention mentionnées ci-dessus, ainsi que d'autres, apparaîtront plus clairement à la lecture de la description suivante d'au moins un exemple de réalisation, ladite description étant faite en relation avec les dessins joints, parmi lesquels :
[Fig. 1] illustre schématiquement, en vue de côté, un aéronef équipé d'un système de surveillance de la performance d'un interrupteur électromécanique, de type contacteur ou relais compris dans un système de distribution d'énergie électrique au sein de cet aéronef ;
[Fig. 2] illustre schématiquement un exemple d'architecture matérielle du système de surveillance de la performance d'un interrupteur électromécanique ;
[Fig. 3] illustre schématiquement un premier exemple d'algorithme de surveillance de la performance d'un interrupteur électromécanique ;
[Fig. 4] illustre schématiquement un exemple de système de distribution d'énergie électrique comprenant une pluralité d'interrupteurs électromécaniques dont il est proposé de surveiller la performance ;
[Fig. 5] illustre schématiquement trois exemples de vérification d'un éventuel changement d'état d'un interrupteur électromécanique lié, suite à un changement d'état d'un interrupteur électromécanique donné ;
[Fig. 6] illustre schématiquement un deuxième exemple d'algorithme de surveillance de la performance d'un interrupteur électromécanique ;
[Fig. 7] illustre schématiquement un troisième exemple d'algorithme de surveillance de la performance d'un interrupteur électromécanique ; et
[Fig. 8] illustre schématiquement un exemple d'algorithme de maintenance d'un interrupteur électromécanique compris dans un système de distribution d'énergie électrique au sein de cet aéronef.

### EXPOSE DETAILLE DE MODES DE REALISATION

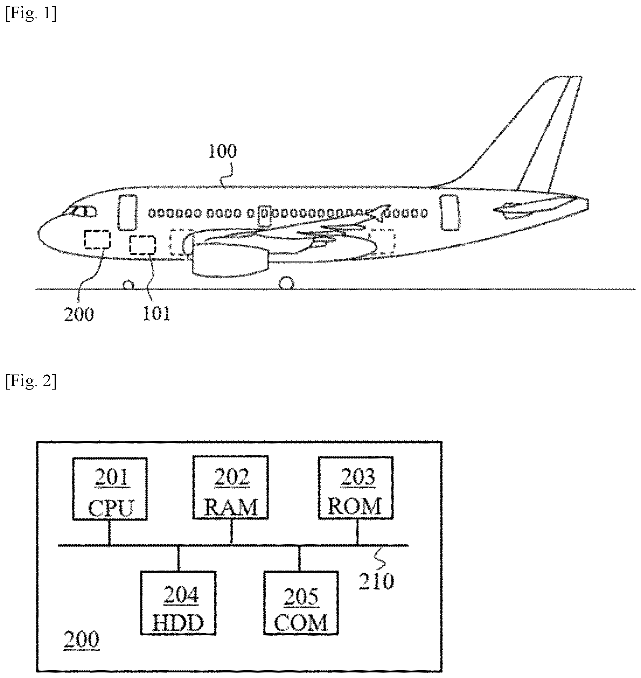

La **Fig. 1** illustre schématiquement, en vue de côté, un aéronef 100 équipé d'un système 101 de distribution d'énergie électrique et d'un système 200 de surveillance de la performance d'interrupteurs électromécaniques, de type contacteur ou relais, compris dans le système 101 de distribution d'énergie électrique.

Le système 101 de distribution d'énergie électrique au sein de l'aéronef est par exemple compris dans un centre de distribution d'énergie électrique (EPDC, pour « Electrical Power Distribution Center » en anglais). Il est typiquement responsable de la distribution de l'énergie électrique dans l'ensemble de l'aéronef, y compris les moteurs, les systèmes de commande de vol, les équipements de navigation et les systèmes passagers. Le système 101 est par exemple divisé en deux sections principales : le système de distribution d'énergie AC et le système de distribution d'énergie DC. Le système de distribution de l'énergie AC est chargé de distribuer aux différents systèmes et équipements de l'aéronef l'énergie en courant alternatif (AC, pour « Alternating Current » en anglais) générée par différentes sources électriques, par exemple un groupe auxiliaire de puissance (APU, pour « Auxiliary Power Unit » en anglais) de l'aéronef, un groupe électrogène au sol (GPU, pour « Ground Power Unit » en anglais) ou un générateur électrique lorsque le moteur associé de l'aéronef est allumé (« Generator », IDG pour « Integrated Drive Generator » ou VFG pour « Variable Frequency Generator » en anglais). Le système de distribution de courant continu (DC, pour « Direct Current » en anglais) est chargé de distribuer aux différents systèmes et équipements de l'aéronef le courant continu produit par différentes sources électriques, par exemple des batteries ou des transformateurs redresseurs (TRU, pour « Transformer Rectifier Unit » en anglais) de l'aéronef.

Le système 101 de distribution d'énergie électrique comprend une pluralité d'interrupteurs électromécaniques, de type contacteur ou relais, configurés chacun pour passer d'un état « ouvert » à un état « fermé » ou inversement, en fonction d'un signal de commande. Le système 101 de distribution d'énergie électrique comprend une logique de contrôle et de reconfiguration, générant les signaux de contrôle pour les différents interrupteurs électromécaniques. En fonctionnement normal, les interrupteurs électromécaniques ne changent pas de statut, sauf en cas de reconfiguration souhaitée du système de distribution d'énergie électrique. Chaque reconfiguration du système de distribution d'énergie électrique est fonction d'une disponibilité des sources électriques du système de distribution d'énergie électrique (APU, GPU, IDG, VFG, batteries, TRU...).

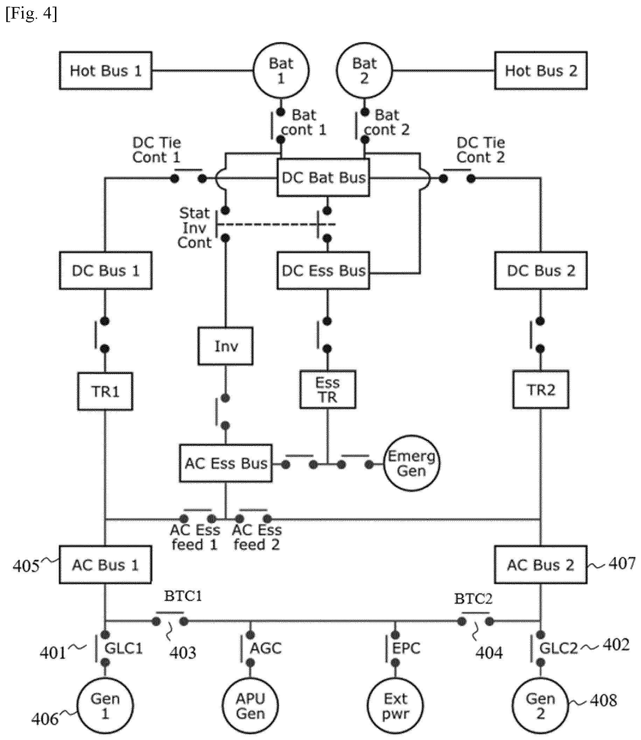

Par exemple, le système de distribution d'énergie électrique illustré sur la **Fig. 4** comprend des contacteurs GLC1 et GLC2 (contacteurs de ligne de générateur, référencés 401 et 402) et des contacteurs BTC1 et BTC2 (contacteurs de transfert de bus, référencés 403 et 404) qui sont commandés pour que le bus AC BUS 1 (référencé 405) soit alimenté par la source électrique GEN 1 (référencée 406) et le bus AC BUS 2 (référencé 407) par la source électrique GEN 2 (référencée 408).

Un interrupteur électromécanique se compose généralement d'une bobine, de contacts et d'un boîtier de protection. Lorsque la bobine est alimentée, un champ magnétique est créé qui rapproche ou éloigne les contacts, fermant ou ouvrant ainsi le circuit selon la conception de l'interrupteur électromécanique, ce qui permet de contrôler le courant qui circule vers une charge électrique connectée.

On connaît principalement deux types d'interrupteur électromécanique : les contacteurs, destinés à réguler le flux de courant électrique dans des applications de haute puissance, et les relais, destinés à réguler le flux de courant électrique dans les applications de faible à moyenne puissance. En d'autres termes, les contacteurs et les relais partagent des principes de construction similaires, et les contacteurs sont spécifiquement optimisés pour les applications de haute puissance grâce à des choix de conception (par exemple, des contacts plus grands, des matériaux de meilleure qualité, une suppression d'arc plus efficace et une construction mécanique plus solide).

Un interrupteur électromécanique peut subir différentes pannes, par exemple du fait par exemple d'un défaut de la bobine, provoquant une interruption de fonctionnement qui peut être temporaire (par exemple de quelques millisecondes ou quelques secondes ; on parle parfois dans ce cas de « micro-interruption », « micro-coupure » ou encore « micro-switch »), ou bien définitive. Une telle interruption de fonctionnement se traduit par un changement d'état non souhaité (anormal) de l'interrupteur électromécanique, depuis un état « ouvert » vers un état « fermé » ou inversement. Dans le cas d'une micro-interruption, il y a également un deuxième changement d'état non souhaité, pour revenir à l'état correct initial.

Comme détaillé par la suite, le système 200 de surveillance de la performance d'interrupteurs électromécaniques, de type contacteur ou relais, permet de déclencher une alerte (par l'exemple l'affichage d'une information et/ou l'envoi d'un message à un service de maintenance) si une condition de déclenchement est vérifiée. En outre, comme également détaillé par la suite, le déclenchement d'une alerte relative à un interrupteur électromécanique donné peut être suivi d'au moins une opération de maintenance sur cet interrupteur électromécanique donné (par exemple la réparation de ce dernier ou bien son remplacement).

Dans une implémentation particulière, le système 200 de surveillance de la performance d'interrupteurs électromécaniques est un équipement électronique embarqué. Par exemple, il fait partie d'une circuiterie électronique de l'avionique de l'aéronef 100. Préférentiellement, il est intégré à un calculateur de l'aéronef 100.

Dans une variante, le système 200 de surveillance de la performance d'interrupteurs électromécaniques n'est pas embarqué dans l'aéronef 100 mais est présent au sol.

Dans une autre variante, le système 200 de surveillance de la performance d'interrupteurs électromécaniques comprend une première partie qui est embarquée dans l'aéronef 100 et une deuxième partie qui est présente au sol. Ainsi, les calculs et le déclenchement des alertes peuvent être répartis entre les deux parties du système 101.

Dans une autre variante, au moins un système 200 de surveillance de la performance d'interrupteurs électromécaniques est embarqué dans l'aéronef et au moins un système 200 de surveillance de la performance d'interrupteurs électromécaniques est installé au sol.

La **Fig. 2** illustre schématiquement un exemple d'architecture matérielle du système 200 de surveillance de la performance d'interrupteurs électromécaniques, qui comprend alors, reliés par un bus de communication 210 : un processeur ou CPU (« Central Processing Unit » en anglais) 201 ; une mémoire vive RAM (« Random Access Memory » en anglais) 202 ; une mémoire morte ROM (« Read Only Memory » en anglais) 203, par exemple une mémoire Flash ; un dispositif de stockage de données, tel qu'un disque dur HDD (« Hard Disk Drive » en anglais), ou un lecteur de support de stockage, tel qu'un lecteur de cartes SD (« Secure Digital » en anglais) 204 ; au moins une interface de communication 205 permettant au système 200 de surveillance de la performance d'interrupteurs électromécaniques d'interagir dans l'avionique de l'aéronef 100.

Le processeur 201 est capable d'exécuter des instructions chargées dans la RAM 202 à partir de la ROM 203, d'une mémoire externe (non représentée), d'un support de stockage, tel qu'une carte SD, ou d'un réseau de communication (non représenté). Lorsque le système 200 de surveillance de la performance d'interrupteurs électromécaniques est mis sous tension, le processeur 201 est capable de lire de la RAM 202 des instructions et de les exécuter. Ces instructions forment un programme d'ordinateur causant la mise en œuvre, par le processeur 201, des comportements, étapes et algorithme décrits ici.

Tout ou partie des comportements, étapes et algorithme décrits ici peut ainsi être implémenté sous forme logicielle par exécution d'un ensemble d'instructions par une machine programmable, telle qu'un DSP (« Digital Signal Processor » en anglais) ou un microcontrôleur, ou être implémenté sous forme matérielle par une machine ou un composant (« chip » en anglais) dédié ou un ensemble de composants (« chipset » en anglais) dédié, tel qu'un FPGA (« Field-Programmable Gate Array » en anglais) ou un ASIC (« Application-Specific Integrated Circuit » en anglais). D'une manière générale, le système 200 de surveillance de la performance d'interrupteurs électromécaniques comprend de la circuiterie électronique agencée et configurée pour implémenter les comportements, étapes et algorithmes décrits ici.

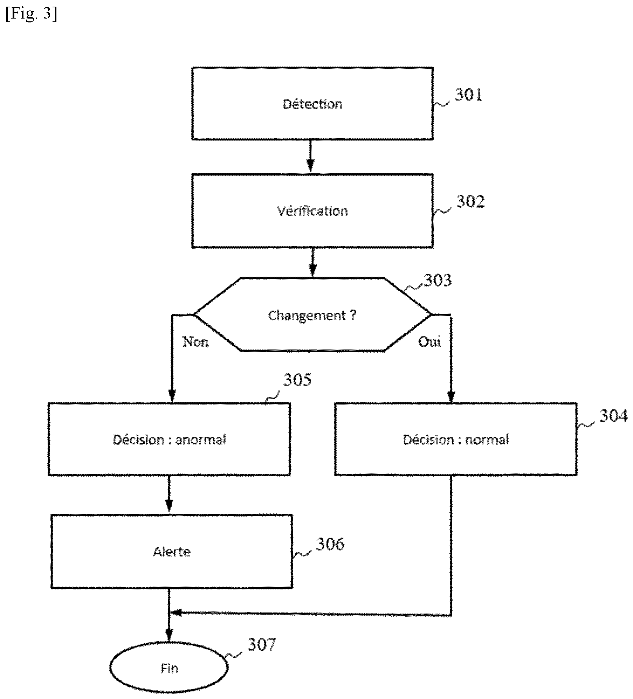

La **Fig. 3** illustre schématiquement un premier exemple d'algorithme de surveillance de la performance d'un interrupteur électromécanique, de type contacteur ou relais, compris dans le système 101 de distribution d'énergie électrique au sein d'un aéronef. Le procédé est implémenté par le système de surveillance 200 discuté ci-dessus en relation avec les Fig. 1 et 2.

Dans une étape 301, le système de surveillance 200 détecte un changement d'état d'un interrupteur électromécanique donné, depuis un état « ouvert » vers un état « fermé » ou inversement, en fonction de données collectées informant sur l'état de l'interrupteur électromécanique donné.

Dans une étape 302, le système de surveillance 200 vérifie, pour chaque interrupteur électromécanique lié appartenant à un groupement prédéterminé (voir définition ci-après), si l'interrupteur électromécanique lié a également subi un changement d'état, depuis un état « ouvert » vers un état « fermé » ou inversement, en fonction de données collectées informant sur l'état de l'interrupteur électromécanique lié.

Le groupement prédéterminé comprend un ou plusieurs interrupteurs électromécaniques qui sont liés à l'interrupteur électromécanique donné et font partie de la pluralité d'interrupteurs électromécaniques. Plus précisément, chaque interrupteur électromécanique lié du groupement est configuré, par la logique de contrôle et de reconfiguration (déjà discutée plus haut), pour changer d'état si l'interrupteur électromécanique donné change d'état dans le cadre d'une reconfiguration particulière du système de distribution d'énergie électrique qui est fonction d'une disponibilité des sources électriques (APU, GPU, IDG, VFG, batteries, TRU...).

Dans le cas où la logique de contrôle et de reconfiguration gère plusieurs reconfigurations possibles du système de distribution d'énergie électrique, le groupement comprend :
- au moins un premier interrupteur électromécanique lié qui est configuré, par la logique de contrôle et de reconfiguration, pour changer d'état si l'interrupteur électromécanique donné change d'état dans le cadre d'une première reconfiguration particulière du système de distribution d'énergie électrique qui est fonction d'un premier contexte de disponibilité des sources électriques (par exemple, avec le système de distribution d'énergie électrique de la Fig. 4, en cas de perte de la source électrique GEN 1 alors que les sources électriques GEN 1 et GEN 2 étaient toutes les deux allumées et utilisées, la reconfiguration va consister à utiliser la source électrique GEN 2 mais plus la source électrique GEN 1) ; et
- au moins un deuxième interrupteur électromécanique lié qui est configuré, par la logique de contrôle et de reconfiguration, pour changer d'état si l'interrupteur électromécanique donné change d'état dans le cadre d'une deuxième reconfiguration particulière du système de distribution d'énergie électrique qui est fonction d'un deuxième contexte de disponibilité des sources électriques (par exemple, toujours avec le système de distribution d'énergie électrique de la Fig. 4, en cas de perte de la source électrique GEN 1 alors que les sources électriques GEN 1 et APU étaient toutes les deux allumées et utilisées, la reconfiguration va consister à passer à utiliser la source électrique APU mais plus la source électrique GEN 1).

On notera que, si l'interrupteur électromécanique donné change d'état dans le cadre de la première reconfiguration particulière du système de distribution d'énergie électrique, le au moins un premier interrupteur électromécanique lié doit normalement lui aussi changer d'état, mais pas le au moins un deuxième interrupteur électromécanique lié.

En reprenant l'exemple de système de distribution d'énergie électrique illustré sur la Fig. 4 : pour le contacteur GLC1 (référencé 401), le groupement associé comprend un seul contacteur lié, à savoir le contacteur BTC1 (référencé 403) ; et pour le contacteur GLC2 (référencé 402), le groupement associé comprend un seul contacteur lié, à savoir le contacteur BTC2 (référencé 404).

Si au moins un interrupteur électromécanique lié du groupement a également subi un changement d'état (réponse « oui » à l'étape de test 303), le système de surveillance 200 exécute une étape 304, dans laquelle il considère que le changement d'état de l'interrupteur électromécanique donné est normal, avant de passer à une étape de fin 307. En effet, si au moins un interrupteur électromécanique lié du groupement a également subi un changement d'état, on peut en déduire que l'interrupteur électromécanique donné n'est pas défectueux car s'il était défectueux il y a une probabilité quasi nulle qu'un interrupteur électromécanique du groupement (celui qui change également d'état) soit également défectueux au même moment. On notera qu'il suffit qu'au moins un des interrupteurs électromécaniques du groupement change également d'état pour prendre la décision de changement d'état normal pour l'interrupteur électromécanique donné, car la configuration courante du système de distribution d'énergie (et donc l'état courant de l'ensemble des interrupteurs électromécaniques décidé par la logique de contrôle et de reconfiguration) est fonction d'un contexte courant de disponibilité des sources électriques.

Sinon (réponse « non » à l'étape de test 303), c'est-à-dire si aucun interrupteur électromécanique lié du groupement n'a subi un changement d'état, le système de surveillance 200 exécute une étape 305 dans laquelle il considère que le changement d'état de l'interrupteur électromécanique donné est anormal, puis une étape 306 dans laquelle il déclenche une alerte relative à la performance de l'interrupteur électromécanique donné, avant de passer à l'étape de fin 307.

Dans une implémentation particulière, la vérification d'un changement d'état (à l'étape 302), pour chaque interrupteur électromécanique lié appartenant au groupement, est limitée à une fenêtre temporelle de vérification, possédant une durée prédéterminée et entourant un instant de détection d'un changement d'état de l'interrupteur électromécanique donné.

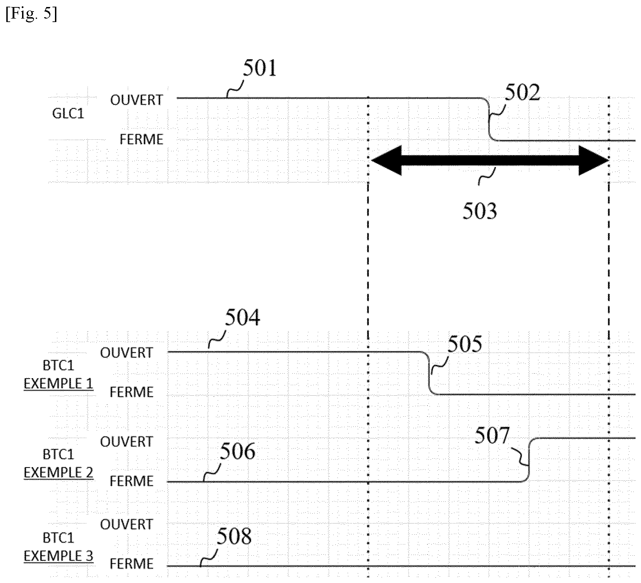

Cette implémentation particulière est illustrée sur la **Fig. 5****.** On suppose que l'interrupteur électromécanique dont on surveille la performance est le contacteur GLC1 (référencé 401 sur la Fig. 4). La ligne d'état 501 représente l'état de ce contacteur GLC1, avec dans cet exemple un changement d'état (depuis l'état « ouvert » vers l'état « fermé ») à un instant référencé 502 (instant de détection de changement d'état). Pour chaque interrupteur électromécanique lié (c'est-à-dire appartenant au groupement associé au contacteur GLC1), la vérification d'un changement d'état est limitée à la fenêtre temporelle de vérification référencée 503. Comme mentionné plus haut, on suppose que, pour le contacteur GLC1, le groupement associé comprend un seul contacteur lié, à savoir le contacteur BTC1 (référencé 403 sur la Fig. 4). Trois exemples de vérification d'un éventuel changement d'état du contacteur BTC1, suite au changement d'état du contacteur GLC1, sont illustrés sur la Fig. 5 :
- premier exemple : la ligne d'état 504 représente l'état du contacteur BTC1, avec un changement d'état (depuis l'état « ouvert » vers l'état « fermé ») à un instant référencé 505 qui est compris dans la fenêtre temporelle de vérification 503 ; par conséquent, le système de surveillance 200 considère que le changement d'état du contacteur GLC1 est normal ;
- deuxième exemple : la ligne d'état 506 représente l'état du contacteur BTC1, avec un changement d'état (depuis l'état « fermé » vers l'état « ouvert ») à un instant référencé 507 qui est compris dans la fenêtre temporelle de vérification 503 ; par conséquent, le système de surveillance 200 considère que le changement d'état du contacteur GLC1 est normal ;
- troisième exemple : la ligne d'état 508 représente l'état du contacteur BTC1 (unique contacteur lié du groupement), avec aucun changement d'état dans la fenêtre temporelle de vérification 503 ; par conséquent, le système de surveillance 200 considère que le changement d'état du contacteur GLC1 est anormal.

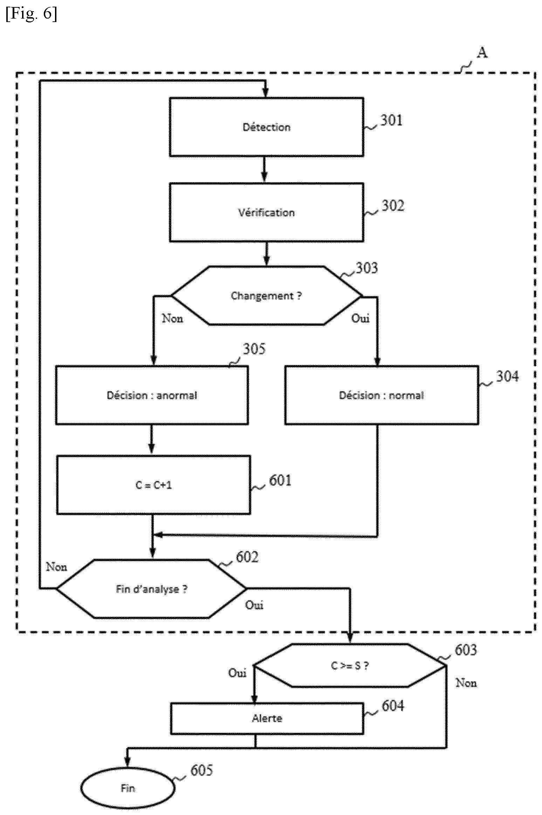

La **Fig. 6** illustre schématiquement un deuxième exemple d'algorithme de surveillance de la performance d'un interrupteur électromécanique.

Les étapes 301 à 305 sont identiques à celles du premier exemple d'algorithme de la Fig. 3. Ce deuxième exemple d'algorithme se distingue du premier en ce que, en cas de réponse « non » à l'étape de test 303 (c'est-à-dire si aucun interrupteur électromécanique lié du groupement n'a subi un changement d'état), et après exécution de l'étape 305 (dans laquelle il considère que le changement d'état de l'interrupteur électromécanique donné est anormal), le système de surveillance 200 exécute une étape 601 dans laquelle il incrémente un compteur C de changement d'état anormal, puis une étape 602 dans laquelle il vérifie si une période temporelle de collecte (des données informant sur l'état des interrupteurs électromécaniques) a été entièrement analysée.

Dans un mode de réalisation, la période temporelle prédéterminée de collecte est une partie d'une plage temporelle d'un vol de l'aéronef, définie en fonction d'un paramètre de phase de vol de l'aéronef. Par exemple, les phases 2 à 9 dans le cas d'un vol découpé en dix phases (1 : Roulage au décollage (Takeoff Roll) ; 2 : Décollage (Takeoff) ; 3 : Montée initiale (Initial Climb) ; 4 : Montée sur la trajectoire (On-Course Climb) ; 5 : Montée en croisière (Cruise Climb) ; 6 : Croisière (Cruise) ; 7 : Descente initiale (Initial Descent) ; 8 : Descente d'approche (Approach Descent) ; 9 : Descente finale (Final Descent) ; 10 : Atterrissage (Landing)).

Dans une variante, on considère plusieurs vols de l'aéronef et la période temporelle prédéterminée de collecte est une concaténation des périodes temporelles de collecte (par exemple les phases 2 à 9) de chaque vol.

Si la période temporelle de collecte n'a pas été entièrement analysée, le système de surveillance 200 revient à l'étape 301 (afin de détecter un nouveau changement d'état de l'interrupteur électromécanique donné, dont on surveille la performance).

Si la période temporelle de collecte a été entièrement analysée, le système de surveillance 200 exécute une étape 603 dans laquelle il vérifie si la valeur du compteur C est supérieure ou égale à un seuil prédéterminé S. Si la valeur du compteur C est supérieure ou égale au seuil prédéterminé S, le système de surveillance 200 exécute une étape 604 dans laquelle il déclenche une alerte relative à la performance de l'interrupteur électromécanique donné, avant de passer à l'étape de fin 605. Si la valeur du compteur C est inférieure au seuil prédéterminé S, le système de surveillance 200 passe directement à l'étape de fin 605. En d'autres termes, l'alerte relative à la performance de l'interrupteur électromécanique donné est déclenchée (étape 604) si le nombre C de changement d'état anormal de l'interrupteur électromécanique donné, sur la (au moins une) période temporelle prédéterminée de collecte, est supérieur ou égal au seuil prédéterminé S. Dans un mode de réalisation, S=1. D'autres modes de réalisation sont possibles, avec des valeurs de S supérieures à 1.

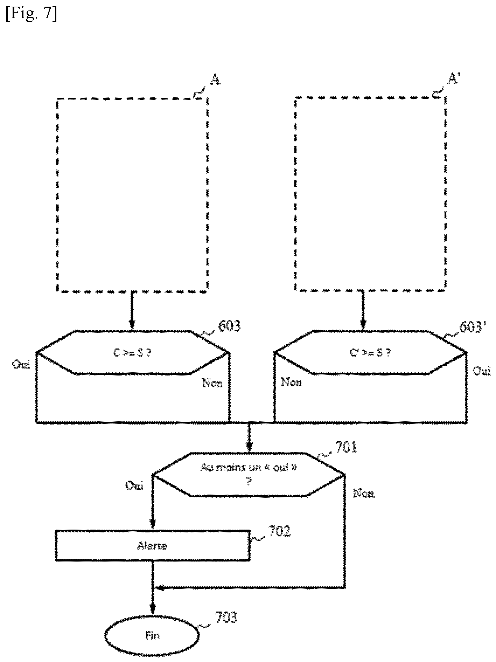

La **Fig. 7** illustre schématiquement un troisième exemple d'algorithme de surveillance de la performance d'un interrupteur électromécanique.

On référence A le groupe d'étapes comprenant les étapes 301 à 305, 601 et 602 de la Fig. 6. On suppose que le groupe d'étapes A est exécuté avec des données collectées par un premier enregistreur (par exemple un premier SDAC, pour « System Data Acquisition Concentrator » en anglais). Le groupe d'étapes A (et plus précisément l'étape 602 de ce groupe) est suivie d'une étape 603 dans laquelle le système de surveillance 200 vérifie si la valeur du compteur C est supérieure ou égale à un seuil prédéterminé S.

On suppose en outre qu'un groupe d'étapes A', comprenant les mêmes étapes que le groupe A, est exécuté avec des données collectées par un deuxième enregistreur (par exemple un deuxième SDAC). Par analogie avec le compteur C utilisé dans le groupe d'étapes A, on nomme C' le compteur utilisé dans le groupe d'étapes A'. Le groupe d'étapes A' (et plus précisément l'étape 602 de ce groupe) est suivie d'une étape 603' dans laquelle le système de surveillance 200 vérifie si la valeur du compteur C' est supérieure ou égale à un seuil prédéterminé S'.

A l'issue des étapes 603 et 603' (exécutées en parallèle, de même que les groupes d'étapes A et A), le système de surveillance 200 exécute une étape 701 dans laquelle il vérifie si au moins un des tests des étapes 603 et 603' est positif. Si au moins un des tests des étapes 603 et 603' est positif, le système de surveillance 200 exécute une étape 702 dans laquelle il déclenche une alerte relative à la performance de l'interrupteur électromécanique donné, avant de passer à l'étape de fin 703. Sinon, le système de surveillance 200 passe directement à l'étape de fin 703.

Le mode de réalisation de la Fig. 7 est aisément généralisable à N groupes d'étapes A, A' etc. (avec N>1), suivi chacun d'une étape 603, 603' etc., puis les étapes communes 701 et 702.

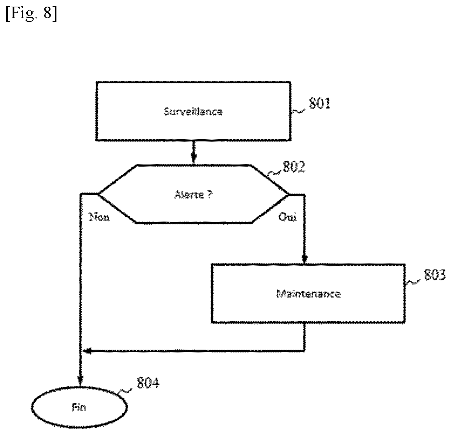

La **Fig. 8** illustre schématiquement un exemple d'algorithme de maintenance d'un interrupteur électromécanique compris dans un système de distribution d'énergie électrique au sein de cet aéronef.

Dans une étape 801, le système de surveillance 200 exécute un algorithme de surveillance de la performance d'un interrupteur électromécanique, dans l'un des modes de réalisation décrits plus haut (voir la description des Fig. 3, 6 et 7).

Si une alerte a été déclenchée à l'issue de l'étape 801 (résultat « oui » à l'étape de test 802), au moins une opération de maintenance, sur l'interrupteur électromécanique donné, est réalisée (étape 803).

## Revendications

1. Procédé de surveillance d'une performance d'un interrupteur électromécanique donné (401) parmi une pluralité d'interrupteurs électromécaniques, de type contacteur ou relais, compris dans un système (101) de distribution d'énergie électrique au sein d'un aéronef (100), le procédé étant implémenté par un système (200) de surveillance sous forme de circuiterie électronique, le procédé comportant :
a) détecter (301) un changement d'état de l'interrupteur électromécanique donné (401), depuis un état « ouvert » vers un état « fermé » ou inversement, en fonction de données collectées informant sur l'état de l'interrupteur électromécanique donné ;
b) vérifier (302), pour chaque interrupteur électromécanique lié (402) appartenant à un groupement prédéterminé comprenant un ou plusieurs interrupteurs électromécaniques qui sont liés à l'interrupteur électromécanique donné et font partie de la pluralité d'interrupteurs électromécaniques, si ledit interrupteur électromécanique lié a également subi un changement d'état, depuis un état « ouvert » vers un état « fermé » ou inversement, en fonction de données collectées informant sur l'état de l'interrupteur électromécanique lié, chaque interrupteur électromécanique lié du groupement étant configuré, par une logique de contrôle et de reconfiguration, pour changer d'état si l'interrupteur électromécanique donné change d'état dans le cadre d'une reconfiguration particulière du système de distribution d'énergie électrique qui est fonction d'une disponibilité de sources électriques du système de distribution d'énergie électrique ;
c) considérer que le changement d'état de l'interrupteur électromécanique donné est normal (304), si au moins un interrupteur électromécanique lié du groupement a également subi un changement d'état, ou anormal (305), si aucun interrupteur électromécanique lié du groupement n'a subi un changement d'état ; et
d) en cas de changement d'état anormal de l'interrupteur électromécanique donné, déclencher (306) une alerte relative à la performance de l'interrupteur électromécanique donné.

2. Procédé selon la revendication 1, dans lequel le groupement comprend :
- au moins un premier interrupteur électromécanique lié qui est configuré, par la logique de contrôle et de reconfiguration, pour changer d'état si l'interrupteur électromécanique donné change d'état dans le cadre d'une première reconfiguration particulière du système de distribution d'énergie électrique qui est fonction d'un premier contexte de disponibilité des sources électriques du système de distribution d'énergie électrique ; et
- au moins un deuxième interrupteur électromécanique lié qui est configuré, par la logique de contrôle et de reconfiguration, pour changer d'état si l'interrupteur électromécanique donné change d'état dans le cadre d'une deuxième reconfiguration particulière du système de distribution d'énergie électrique qui est fonction d'un deuxième contexte de disponibilité des sources électriques du système de distribution d'énergie électrique.

3. Procédé selon l'une quelconque des revendications 1 et 2, dans lequel les opérations a), b) et c) sont exécutées N fois en parallèle (A, A'), N>1, avec à chaque fois des données collectées par un enregistreur distinct,
et dans lequel l'alerte relative à la performance de l'interrupteur électromécanique donné est déclenchée (702) si, à l'issue d'au moins une des N exécutions des étapes a), b) et c), le changement d'état de l'interrupteur électromécanique donné est considéré anormal.

4. Procédé selon l'une quelconque des revendications 1 à 3, dans lequel, pour au moins une période temporelle prédéterminée de collecte des données informant sur l'état de l'interrupteur électromécanique donné, les opérations b) et c) sont exécutées (302 à 305) après chaque détection (301) d'un changement d'état de l'interrupteur électromécanique donné,
et dans lequel l'alerte relative à la performance de l'interrupteur électromécanique donné est déclenchée (604) si le nombre de changement d'état anormal de l'interrupteur électromécanique donné, sur la au moins une période temporelle prédéterminée de collecte, est supérieur ou égal à un seuil prédéterminé (603).

5. Procédé selon la revendication 4, dans lequel chaque période temporelle prédéterminée de collecte est une partie d'une plage temporelle d'un vol de l'aéronef définie en fonction d'un paramètre de phase de vol de l'aéronef.

6. Procédé selon l'une quelconque des revendications 1 à 5, dans lequel la vérification (302) d'un changement d'état, pour chaque interrupteur électromécanique lié appartenant au groupement, est limitée à une fenêtre temporelle de vérification (503), possédant une durée prédéterminée et entourant un instant de détection d'un changement d'état (502) de l'interrupteur électromécanique donné.

7. Produit programme d'ordinateur, comportant des instructions entraînant l'exécution, par un processeur (201), du procédé selon l'une quelconque des revendications 1 à 6, lorsque lesdites instructions sont exécutées par le processeur.

8. Support de stockage (203), stockant un programme d'ordinateur comportant des instructions entraînant l'exécution, par un processeur (201), du procédé selon l'une quelconque des revendications 1 à 6, lorsque lesdites instructions sont lues et exécutées par le processeur.

9. Système (200) de surveillance d'une performance d'un interrupteur électromécanique donné (401) parmi une pluralité d'interrupteurs électromécaniques, de type contacteur ou relais, compris dans un système (101) de distribution d'énergie électrique au sein d'un aéronef (100), le système de surveillance comprenant une circuiterie électronique configurée pour implémenter :
a) détecter (301) un changement d'état de l'interrupteur électromécanique donné (401), depuis un état « ouvert » vers un état « fermé » ou inversement, en fonction de données collectées informant sur l'état de l'interrupteur électromécanique donné ;
b) vérifier (302), pour chaque interrupteur électromécanique lié (402) appartenant à un groupement prédéterminé comprenant un ou plusieurs interrupteurs électromécaniques qui sont liés à l'interrupteur électromécanique donné et font partie de la pluralité d'interrupteurs électromécaniques, si ledit interrupteur électromécanique lié a également subi un changement d'état, depuis un état « ouvert » vers un état « fermé » ou inversement, en fonction de données collectées informant sur l'état de l'interrupteur électromécanique lié, chaque interrupteur électromécanique lié du groupement étant configuré, par une logique de contrôle et de reconfiguration, pour changer d'état si l'interrupteur électromécanique donné change d'état dans le cadre d'une reconfiguration particulière du système de distribution d'énergie électrique qui est fonction d'une disponibilité de sources électriques du système de distribution d'énergie électrique ;
c) considérer que le changement d'état de l'interrupteur électromécanique donné est normal (304), si au moins un interrupteur électromécanique lié du groupement a également subi un changement d'état, ou anormal (305), si aucun interrupteur électromécanique lié du groupement n'a subi un changement d'état ; et
d) en cas de changement d'état anormal de l'interrupteur électromécanique donné, déclencher (306) une alerte relative à la performance de l'interrupteur électromécanique donné.

10. Procédé de maintenance d'un interrupteur électromécanique donné (401) parmi une pluralité d'interrupteurs électromécaniques, de type contacteur ou relais, compris dans un système (101) de distribution d'énergie électrique au sein d'un aéronef (100), le procédé comportant :
- exécuter (801) le procédé selon l'une quelconque des revendications 1 à 6, pour surveiller la performance de l'interrupteur électromécanique donné ; et
- en cas de déclenchement (802) d'une alerte relative à la performance de l'interrupteur électromécanique donné, réaliser (803) au moins une opération de maintenance sur l'interrupteur électromécanique donné.
